**Europäisches Patentamt**

**European Patent Office**

**Office européen des brevets**

(11) Veröffentlichungsnummer: **0 216 090**

**A1**

## (12) EUROPÄISCHE PATENTANMELDUNG

(21) Anmeldenummer: 86110759.7

(22) Anmeldetag: 04.08.86

(51) Int. Cl.⁴: **H01L 23/46**

(30) Priorität: 30.08.85 DE 3531136

(43) Veröffentlichungstag der Anmeldung:
01.04.87 Patentblatt 87/14

(84) Benannte Vertragsstaaten:
DE FR GB IT

(71) Anmelder: **Siemens Aktiengesellschaft Berlin
und München**
**Wittelsbacherplatz 2**
**D-8000 München 2(DE)**

(72) Erfinder: **Buselmeier, Bernhard, Dipl.-Ing. FH**
**Minervusstrasse 2**
**D-8000 München 19(DE)**
Erfinder: **Prussas, Herbert, Dipl.-Ing.**
**Mozartring 11**
**D-8069 Reichertshausen/Ilm(DE)**

(54) **Gehäuse für ein im Betrieb Verlustwärme abgebendes Schaltungsbauteil.**

(57) Gehäuse (W/G1/G) für ein im Betrieb Verlustwärme abgebendes Schaltungsbauteil (IC). Das Gehäuse (W/G1/G) besteht aus mindestens einer Bodenwanne (G) und einem eine ebene Deckelfläche aufweisenden Deckel (W). Ein rahmenförmiger Sektor (TF) dieser Deckelfläche dient als Auflagefläche (TF) auf eine ebene Auflagefläche (TF) der Seitenwände (GI) der Bodenwanne (G). Beide Auflageflächen (TF) werden schließlich aneinander befestigt. Zumindest Teile der Deckelaußenoberfläche (W) werden im Betrieb durch ein Kühlmedium (KL) gekühlt, wobei Verlustwärme vom Schaltungsbauteil (IC) über einem steifen Wärmeleitkörper (SC, SC2) und ein gut wärmeleitendes, aus elastischem Material bestehendes Element (FE/WS/WL) an den Deckel (W) weitergeleitet wird. Jeweils mindestens ein gut wärmeleitendes, Fiederzungen (WL) aufweisendes Federgebilde (WL/WS) ist in Seitenspalten zwischen den Wärmeleitkörper (SC, SC2) und zumindest zweien der Seitenwände (G1) der Bodenwanne (G) in sich mittels seiner Fiederzungen (WL) spreizender Weise so eingefügt, daß diese Federgebilde - (WL/WS) durch Reibungskräfte haften. Das Element (FE) und die Federgebilde (WS/WL) bilden eine zusammenhängende Federeinheit (FE/WL/WS) aus einem einzigen Stück Federblech mit Mittelteil (FE) und Seitenteilen (WS). Der gut wärmeleitende Deckel (W) ist fest und gut wärmeleitend mit dem Mittelteil (FE) verbunden. Wegen der geometrischen Maße, der Federkräfte und der Reibungskräfte der Federeinheit (FE/WS/WL) stellt -nach dem Aufsetzen des Deckels (W) auf die Bodenwanne (G,G1) aber vor der endgültigen Befestigung des Deckels (W) auf der Bodenwanne (G) -die Federeinheit (FE/WS/WL) eine zentrierende Halterung des Deckels (W) dar, welche ein Verschieben des Deckels (W) gegenüber den Seitenwänden (G1) der Bodenwanne (G) erschwert oder verhindert.

## Gehäuse für ein im Betrieb Verlustwärme abgebendes Schaltungsbauteil.

Die Erfindung stellt eine Verbesserung des im Oberbegriff des Patentanspruches 1 angegebenen speziellen Gehäuses dar, das für sich in den älteren, bisher noch nicht veröffentlichten Europäischen Anmeldungen 85 10 9825.1 (VPA 84 P 1584 E) und 85 10 9827.7 (VPA 84 P 1583 E) beschrieben ist. Der Wärmewiderstand zwischen dem Schaltungsbauteil und dem Kühlmedium wird dort durch eine Wärmeleitplatte, an welcher verschiedene Federgebilde und mindestens ein - (Feder-)Element befestigt ist, wesentlich verringert, also die Kühlung des Schaltungsbauteiles verbessert.

Die Erfindung wurde zwar an sich für ein schon in den älteren Anmeldungen beschriebenes 200-MBit/sec-Lichtsendemodulgehäuse mit einer Infrarot-Sendediode und einem Treiber-Chip entwickelt, wobei die hohe Verlustwärme, z.B. 1 W des im Betrieb z.B. 125° C heißen Treibers, möglichst schnell an das über das Gehäuse strömende Kühlmedium von z.B. 40° C Anfangstemperatur und 100 m/min Geschwindigkeit abzugeben ist. Ohne ganz besondere Kühlmaßnahmen wird der Treiber-Chip zu heiß und ist dann nicht mehr betriebssicher. Die Erfindung eignet sich aber schlechthin auch für ein Gehäuse mit einem an sich beliebigen, gut zu kühlenden Schaltungsbauteil.

Die Aufgabe der Erfindung ist, die Herstellung des Gehäuses zu vereinfachen. Die Aufgabe hat zwei Aspekte:

1. soll mit ganz besonders einfach herstellbaren Mitteln eine gute Wärmeableitung vom Halbleiterkörper zum Kühlmedium erreicht werden, d.h. zur zu kühlenden Kühlaußenoberfläche des Gehäuses, besonders direkt zum Dek kel des Gehäuses, bei Bedarf aber auch zu einzelnen oder zu allen Bodenwanne-Seitenwänden. Die Verlustwärme fließt also vom Schaltungsbauteil

--über die Federgebilde direkt zum Deckel und von dort zum Kühlmedium, und/oder

--über die Federgebilde und über die davon berührten Bodenwanne-Seitenwände und direkt über deren Außenoberflächen zum Kühlmedium, und/oder

--die Federgebilde und über diese Bodenwanne-Seitenwände zuerst weiter zum Deckel und über dessen Außenoberfläche zum Kühlmedium.

Die hierzu dienenden Federgebilde, das Element und der Deckel sollen also besonders einfach herstellbar sein.

2. soll gleichzeitig eine Justierung/Zentrierung des auf die Bodenwanne aufgesetzten, noch nicht auf der Bodenwanne befestigten Deckels mit besonders einfachen Mitteln erreicht werden, so daß bereits ohne zusätzliche Justiermaßnahmen auch in der Massenfertigung die Gefahr des Verrutschens des Deckels beim - z.B. hermetisch dichten -Befestigen des Deckels auf der Bodenwanne, also z.B. beim Verlöten und sogar Rollnahtschweißen, verringert werden. Die Erfindung vereinfacht also auch das Befestigen des Deckels auf der Bodenwanne, indem es nicht mehr nötig ist, zur Vermeidung des Verrutschens des Deckels Justiermaßnahmen wie z.B. zusätzlich Noppen, Anschläge oder Abschrägungen am Deckel und/oder an den Seitenwänden der Bodenwanne anbringen zu müssen. Die Erfindung läßt aber zu, zusätzlich solche Justiermaßnahmen durchzuführen, z.B. um eine noch größere Zentrierpräzision zu erreichen.

Diese Aufgabe der Erfindung wird durch die im Patentanspruch 1 genannten Maßnahmen gelöst.

Die in den Unteransprüchen genannten Maßnahmen gestatten, zusätzliche Vorteile zu erreichen, nämlich die Maßnahmen gemäß Patentanspruch

2, einen Teil der Verlustwärme auch über den Gehäuseboden und von dort z.B. weiter über die Gehäusewände zum Kühlmedium weiterleiten zu können, und/oder

-vorab das Schaltungsbauteil, z.B. einen gehäuselosen Treiber-Chip, fest auf dem Wärmeleitkörper oder auf einem fest mit dem Wärmeleitkörper verbindbaren oder verbundenen Träger, z.B. Keramikträger, montieren und prüfen zu können, z.B. noch bevor der mit dem Schaltungsbauteil bestückte -z.B. metallische, z.B. aus einer CuMo-Legierung bestehende - Wärmeleitkörper in auch für Massenfertigung geeigneter Weise auf dem Boden der Bodenwanne z.B. durch Punktschweißen oder Löten angebracht wird, und/oder

-eine erhöhte Wärmekapazität nahe beim Schaltungsbauteil im Inneren des Gehäuses zur Pufferung von hohen Verlustwärmespitzen erreichen zu können;

3, eine vergrößerte Berührungsfläche zwischen dem Wärmeleitkörper und dem dort berührenden Federgebilde, z.B. zur Verbesserung des Verlustwärmeüberganges vom Wärmeleitkörper zum betreffenden Federgebilde, erreichen zu können, und/oder

-dort einen besonders tiefen Seitenspalt, in welchen das berührende Federgebilde besonders tief und damit besonders gut haftend gesteckt werden kann, herstellen zu können;

4 und 5, eine besonders steife Zentrierung des in die Bodenwanne gesteckten Deckels, vor dessen Befestigung an der Auflagefläche der Bodenwanne-Seitenwände, erreichen zu können, damit

- die Gefahr des Verrutschens des Deckels, bei seiner Befestigung -z.B. durch Rollnahtschweißen - auf der Auflagefläche der Bodenwanne-Seitenwände, besonders stark verringern zu können;

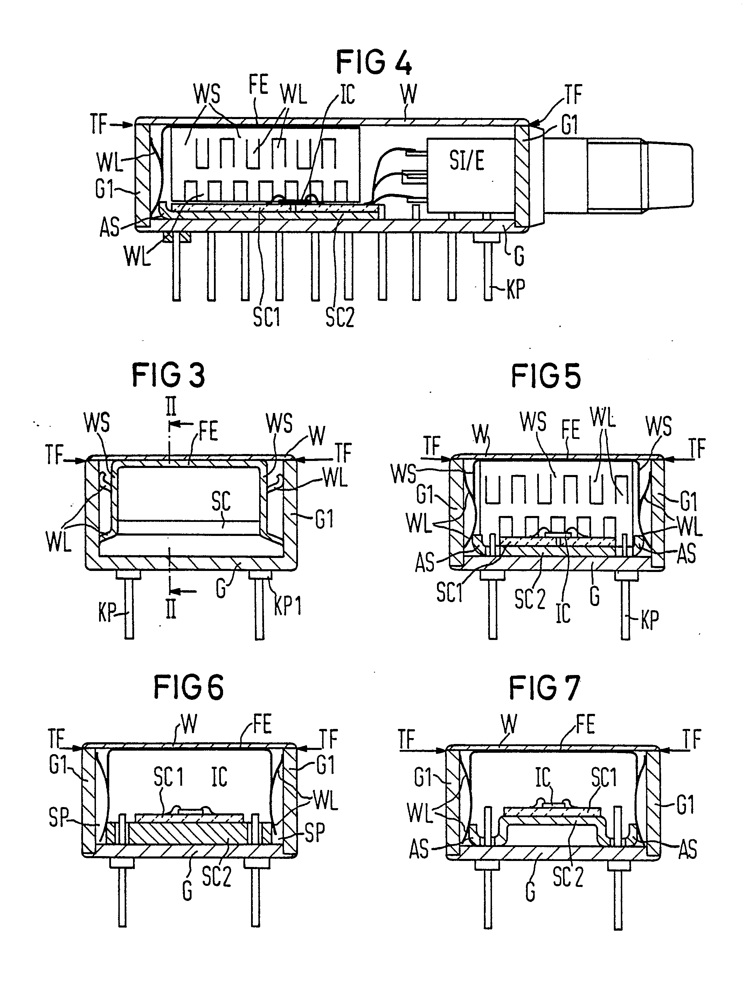

6, einen relativ kleinen Wärmeleitkörper-Wärmeausdehnungskoeffizienten von z.B. $9.10^{-6}$ K;-;1 (z.B. identisch wie der von manchen Keramiken -z.B. von dem in den Figuren 4 bis 7 gezeigten Keramikträger SCI), sowie eine hohe Wärmeleitkörper-Wärmeleitfähigkeit, nämlich z.B. etwa 226 W/m.K, erreichen zu können;

7, eine besonders hohe Federblech-Wärmeleitfähigkeit von z.B. 230 W/m.K bei hoher Federblech-Elastizität erreichen zu können;

8, in für Massenfertigung günstiger Weise einen üblichen Keramikträger als unmittelbaren Schaltungsbauteil-Träger verwenden zu können, wobei das Schaltungsbauteil z.B. ein gegen hohe Temperaturen, also ein gegen einen Verlustwärmestau empfindlicher Chip und/oder z.B. eine gedruckte Widerstands-Schichtschaltung sein kann;

9, auf der Wärmeleitplatte an einer Stelle eine elektrische Isolation und an einer anderen Stelle einen elektrisch leitenden Kontakt zur -(Keramik-)Träger-Unterseite erreichen zu können; sowie

l0,das Schaltungsbauteil, z.B. einen gehäuselosen Halbleiter-Chip welcher gegen bestimmte Gase z.B. Wasserdampf empfindlich ist, -schützen zu können.

Die Erfindung und ihre Weiterbildungen werden anhand der in den Figuren gezeigten Beispiele weiter erläutert. Hierbei zeigt die Figur

1 zur Erläuterung der Aufgabe der Erfindung ein bereits in den älteren Anmeldungen beschriebenes Anwendungsbeispiel für gut zu kühlende -z.B. erfindungsgemäß aufgebaute - Gehäuse unter räumlich äußerst beengten Verhältnissen und entsprechend erschwerter Zufuhr des Kühlmediums;

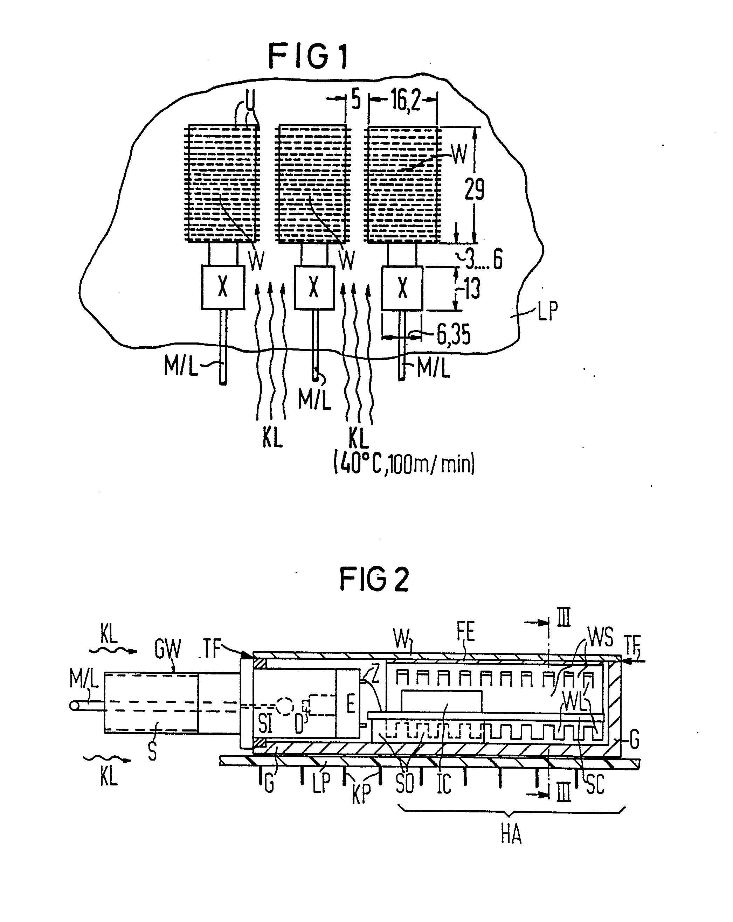

Ferner zeigen die Fig. 2 bis 7 Beispiele der Erfindung, nämlich Figur

2 und 3 ein erstes Beispiel in zwei zueinander senkrechten Schnitten, wobei

--dieses Beispiel ein Gehäuse für ein an eine Glasfaser anzuschließendes Lichtsendemodul eines optoelektronischen Kommunikationssystems darstellt, und

--ein Treiber-Chip als Schaltungsbauteil seine Verlustwärme über die hier zwei Federgebilde/Seitenteile aufweisende Federeinheit an die Gehäuseseitenwand und/oder an den Deckel abgibt;

4 und 5 ein zweites Beispiel in zwei zueinander senkrechten schnitten, wobei

--auch dieses Beispiel ein Gehäuse für ein an eine Glasfaser anzuschließendes Lichtsendemodul darstellt, und

--ein Treiber-Chip als Schaltungsbauteil seine Verlustwärme über die hier drei Seitenteile aufweisende Federeinheit abgibt;

6 ein drittes Beispiel mit sehr massivem Wärmeleitkörper; sowie

7 ein viertes Beispiel mit dünnem hohlen, genauer brückenähnlichen, Wärmeleitkörper.

Die Fig. 1 zeigt nicht die erfindungsgemäßen Maßnahmen. Sie dient im wesentlichen nur zur Erläuterung der Aufgabe der Erfindung durch Veranschaulichung eines extremen Anwendungsfalles, bei welchem sich die anhand der Figuren 2 bis 7 erläuterten erfindungsgemäßen Maßnahmen besonders bewähren.

Diese Fig. 1 zeigt eine Draufsicht auf eine Leiterplatte/Lochplatte LP, in deren Löcher die elektrisch leitenden Steckerstifte der sehr dicht nebeneinander angebrachten Gehäuse gesteckt sind, vgl. die Steckerstifte KP in Fig. 2 und 4, wobei deren Abstandskörper KP1 den Abstand zwischen der Lochplatte LP und der Gehäuse-Unterseite festlegen. Wegen der Draufsicht blickt man in Fig. 1 auf die - z.B. mit vielen Kühlrippchen U ausgestatteten -Deckel W dieser Gehäuse, vgl. auch Fig. 2 und 4, wobei diese Deckel W in Fig. 1 die Sicht auf die darunter liegenden Bodenwannen G, G1 verhindern.

Für viele Anwendungen braucht man extrem viele solche Gehäuse, z.B. für ein optoelektrinisches Fernsprechsystem. Dann sollen die Gehäuse möglichst klein sein, z.B. 48 mm × 16,2 mm × 8,4 mm -vgl. die mm-Angaben in Fig. 1, und, räumlich ganz dicht nebeneinander angebracht, durch kräftige Gebläse gekühlt werden. Das Kühlmedium, -im allgemeinen Kühlluft KL, kühlt zuerst das Nebengehäuse der Lichtsendediode D und danach das Gehäuse des Treiber-Chip IC, und zwar wegen der Platznot oft weitgehend nur über den Deckel W und nur sehr wenig über die sonstigen Oberflächen G/G1./

Trotz der extremen Platznot sollen die Gehäuse oft sehr gut gekühlt werden, selbst wenn die Lichtsendediode D und der Treiber-Chip IC nahe seiner höchstzulässigen Betriebstemperatur betrieben wird. Der hintere Treiber-Chip IC darf bei z.B. 1 W Verlustleistung höchstens z.B. l25°C erreichen. Die Kühlluft KL hat z.B. 100 m/min Geschwindigkeit und 40°C Anfangstemperatur.

Alle in den Figuren 2 bis 7 gezeigten Beispiele dienen z.B. als 200-MBit/sec-Lichtsendemodule. An sich weist daher jedes Beispiel einen optischen Stecker S auf, vgl. z.B. dessen Überwurfmutter X in Fig. 1 sowie dessen Gewinde GW in Fig. 2 sowie dessen ummantelte Glasfaser L mit Mantel M. Jedes Modul wird auch noch, vgl. vor allem in Fig. 2, eine Lichtsendediode D auf, welche sich in einem Nebengehäuse SI/E mit Hohlkörper SI und Verschluß E an einer Seitenwand G1 der Bodenwanne G zwischen dem optischen Stecker S und dem Schaltungsbauteil IC befindet. in den anderen Figuren, vgl. Fig. 2 bis 7, wird diese Glasfaser L und das Nebengehäuse SI/E mit ihrer Lichtsendediode D sowie z.B. die Steckerstifte PK wegen der Übersichtlichkeit nicht gezeigt, um die das Schaltungsbauteil IC kühlenden Federeinheit FE/WS/WL mit Wärmeleitkörper SC, SC1 deutlicher hervorheben zu können. -Die Erfindung betrifft aber nicht nur optoelektronische Gehäuse, sondern Gehäuse nach dem Patentanspruch 1 schlechthin.

Die in den Figuren 2 und 4 dargestellten Beispiele zeigen als Schaltungsbauteil jeweils nur einen Treiber-Chip IC, welcher der Lichtsendediode D vorgeschaltet ist, vgl. die Leitungen Z durch den Verschluß E des Nebengehäuses SI/E. -Die Erfindung betrifft aber beliebige, Verlustwärme abgebende Schaltungsbauteile.

Schon in den beiden älteren Anmeldungen sind ganz besondere Kühlmaßnahmen beschrieben, welche in solchen extremen Fällen gestatten, die Gefahr der Überhitzung des Schaltungsbauteiles zu verringern. Die dort beschriebenen Maßnahmen sind auch beim erfindungsgemäß aufgebauten Gehäuse erfolgreich anwendbar.

Besonders in der erstgenannten älteren Anmeldung ist -besonders anhand der dortigen Figuren 1, 4 und 5 -bereits beschrieben, daß dazu z.B. auch wärmeleitende Federgebilde sowie ein aus elastischen Material hergestelltes, den Deckel berührendes Element zusammen mit einem massiven Wärmeleitkörper in der Weise anwendbar sind, wie es im Oberbegriff des Patentanspruches 1 des vorliegenden Schutzrechtes definiert ist.

Die Erfindung vereinfacht die Herstellung solcher Gehäuse mit Deckel, Wärmeleitkörper, Federgebilden und Element, vor allem

-indem die Herstellung der Fiedergebilde und des Elements als eine einzige gemeinsame Federeinheit aus einem einzigen, z.B. gestanztem und entsprechend gebogenen Federblech ohne Einbuße der Kühlfähigkeit stark vereinfacht wird, sowie

-indem das Befestigen des Deckels auf der Bodenwanne -z.B. das Rollnaht-Aufschweißen des Deckels -durch zusätzliche Ausnutzung dieser Federeinheit als zentrierende, das Ver schieben des Deckels erschwerende/verhindernde Halterung stark vereinfacht wird.

Diese Vereinfachung der Herstellung des Gehäuses wird durch die Erfindung erreicht, obwohl die Erfindung in besonders aufwandsarmer Weise oft mit einer völlig ebenen, also nutfreien und anschlagfreien flachen Scheibe als Deckel auskommen kann, vgl. Fig. 2 bis 7.

Alle in den Fig. 2 bis 7 gezeigten Gehäuse W/G1/G bestehen jeweils aus mindestens zwei Teilen, nämlich aus der Bodenwanne G/G1 und aus einem, eine im wesentlichen ebene Deckelunterseite aufweisenden Deckel W, wobei diese Teile jeweils für sich auch aus mehreren Teilen bestehen mögen, z.B. die Bodenwanne aus einer Bodenplatte G und einem getrennten Seitenwände-Rahmen G1, vgl. die Fig. 4 bis 7.

Ein rahmenförmiger Sektor auf der ebenen Deckelunterseite dient nutfrei und anschlagfrei als Auflagefläche TF für die im wesentlichen ebenfalls ebene zusammenhängende Auflagefläche TF der Seitenwände G1 der Bodenwanne. Die Auflagefläche TF der Seitenwände G1 wird schließlich an dem Sektor TF des Deckels W befestigt, z.B. verlötet oder verschweißt -z.B. rollnahtgeschweißt, wobei z.B. besonders beim Rollnahtschweißen die Gefahr des Verschiebens des auf der Unterseite ebenen Deckels W auf den Seitenwänden G1 besonders groß ist.

Der Deckel W besteht z.B. ganz aus Metall, z.B. aus Vacon (FeNiCo-Legierung), Vacodil (FeNi-Legierung) oder Edelstahl, ebenso z.B. die Bodenwanne.

Im Gehäuse ist eine gut wärmeleitende, wärmezwischenspeichernde Wärmeleitplatte SC oder SC2 befestigt, z.B. in Fig. 2 über einen Sockel SO am Boden der Bodenwanne, und in den Fig. 4 bis 7 direkt an diesem Boden. Zumindest ein Teil der Verlustwärme wird vom Schaltungsbauteil IC über den steifen, im allgemeinen starr mit dem Schaltungsbauteil IC über den steifen, im allgemeinen starr mit dem Schaltungsbauteil IC verbundenen Wärmeleitkörper SC/Fig. 2 und 3 sowie SC2/Fig. 4 bis 7, weiter über die gut wärmeleitende, aus elastischem Material bestehende Federeinheit FE/WS/WL zu dem Deckel W weitergeleitet, wobei die Erfindung zuläßt, daß die Federeinheit FE/WS/WL nach Belieben nur seitlich -also horizontal in den Fig. 2 bis 7, oder anders z.B. zusätzlich vertikal, gegen den massiven, z.B. gestanzten, Wärmeleitkörper SC/SC2 drückt.

Bei der Erfindung spreizt und stemmt sich jeweils ein gut wärmeleitendes, seitliches Federgebilde WL/WS der Federeinheit FE/WS/WL mittels etlichen Fiederzungen in Seitenspalten zwischen den Wärmeleitkörper SC, SC2 und Bodenwanne-Seitenwände, nämlich je ein solches Federgebilde WL/WS zumindest in zwei im wesentlichen parallelen Seitenspalten zwischen dem Wärmeleitkörper SC, SC2 einerseits und zwei einander gegenüberliegenden Seitenwänden G1 andererseits. Dadurch haften die beiden seitlichen Federgebilde WL/WS jeweils durch Reibungskräfte an den Innenoberflächen der Seitenwände G1 sowie an dem Wärmeleitkörper SC, SC2.

Bei der Erfindung bilden das Mittelteil FE der Federeinheit und die Federgebilde WS/WL einschließlich ihrer Fiederzungen WL gemeinsam eine einzige zusammenhängende Federeinheit FE/WL/WS, welche aus einem einzigen Stück Federblech, das einen Mittelteil FE und federnde, die Fiederzungen WL aufweisende Seitenteile WS aufweist, hergestellt ist. Der gut wärmeleitende Deckel W ist fest und gut wärmeleitend mit dem Mittelteil FE der Federeinheit FE/WS/WL verbunden, z.B. punktgeschweißt. Bei der Erfindung besteht zwar der dem Element entsprechende Mittelteil FE der Federeinheit FE/WS/WL also aus Federblech, also aus hochelastischem Material wie das Element der älteren Anmeldung. Bei der Erfindung wird das Mittelteil, welches dem Element der älteren Anmeldungen entspricht, aber nicht in jedem Falle zur Erzeugung von vertikalen Federkräften, also vertikal zum Deckel W, ausgenutzt, vgl. Fig. 2 bis 7.

Die geometrischen Maße, die Federkräfte und damit auch die Reibungskräfte der Federeinheit FE/WS/WL sind so gewählt, daß -nach dem Aufsetzen des Deckels W auf die Seitenwände Gl der Bodenwanne, aber noch vor der endgültigen Befestigung des Deckels W auf den Seitenwänden G1 - die Federeinheit FE/WS/WL eine zentrierende Halterung des Dekkels W bildet, nämlich zumindest eine gewisse, wenn vielleicht auch noch mehr oder weniger federnd nachgebende zentrierende Halterung, welche beim späteren Befestigen des Deckels W ein Verschieben des Deckels W gegenüber den Seitenwänden G1 der Bodenwanne G erschwert oder verhindert. Zum Befestigen des Dekkels W steckt man also die Federeinheit FE/WS/WL so in die Bodenwanne G1/G, daß sich die Federgebilde WS/WL der Federeinheit in die Seitenspalten zwischen dem Wärmeleitkörper SC, SC2 und den betreffenden Seitenwänden G1 hineinschieben und dort durch Reibungskräfte festklemmen, wonach das Verschieben des Deckels W -besonders beim Rollnahtschweißen -auf der Auflagefläche TF der Seitenwände G1 erschwert oder verhindert ist. Nur in Sonderfällen wird man -bevorzugt auf der Deckelaußenoberfläche -eine zusätzliche Zentriermaßnahme wählen, z.B. eine Vertiefung in der an sich beliebig geformten Deckelaußenoberfläche, in welche beim Befestigen/Rollnahtschweißen von außen her ein den Deckel zusätzlich haltender Dorn eingreift. Dann übernimmt aber die erfindungsgemäße Federeinheit vor dem Eingriff des Dornes eine zumindest vorläufige Zentrierung des Deckels -sowohl gegen laterales als auch gegen rotatorisches Verschieben des Deckels, was die Massenfertigung der Gehäuse weiter erheblich erleichtern kann.

Die Fig. 3 zeigt einen senkrechten Schnitt durch die in Fig. 2 gezeigte Ansicht des ersten Beispiels. Fig. 3 zeigt damit einen Schnitt durch die Seitenteile WS der Federeinheit FE/WS/WL, wodurch die abgespreizten Fiederzungen WL und deren stemmende, Reibungskräfte erzeugende Wirkung in den Seitenspalten noch besser als aus FIG. 2 erkennbar sind. Die relativ schmalen federnden Fiederzungen sind auch torsionsfähig und haben daher eine relativ große Berührungsfläche, welche bei Bedarf auch einen besonders guten Wärmeübergang zwischen einerseits der betreffenden Fiederzungen WL und andererseits den von ihr berührten Flächen garantiert, also andererseits z.B. die Bodenwanne-Seitenwand G1 in Fig. 2 bis 7, oder andererseits den Wärmeleitkörper SC in Fig. 2 und 3 sowie SC2 in Fig. 4 bis 7.

Die Fig. 4 bis 7 zeigen drei weitere Gehäusebeispiele, bei welchen der fest mit dem Schaltungsbauteil IC verbundene Wärmeleitkörper SC2 direkt auf dem Boden der Bodenwanne G befestigt ist. Die Aufbauhöhe des Wärmeleitkörpers SC2, also der Abstand seiner oberen Oberfläche zum Boden der Bodenwanne, ist bevorzugterweise so gewählt, daß die Anschlüsse des Schaltungsbauteils IC sowie die Anschlüsse auf einem z.B. aus Keramik bestehenden Schaltungsbauteil-Träger SC1, welche einerseits auch noch Leitungen und z.B. auch diskrete Teile wie Kondensatoren und/ oder Dickschichtschaltungen, also z.B. Schichtwiderstände tragen kann, etwa in derselben Ebene liegen wie die Enden der Steckerstifte KP im Gehäuse-Inneren, z.B. um das nachträgliche Bonden von (z.B. Gold-) Drähten als elektrische Verbindungen zu erleichtern. Dies trifft besonders dann zu,

-wenn zuerst alle elektrischen Teile bis auf die Bonddrähte zuerst auf dem (Keramik-)Träger SC1 angebracht werden,

-wenn dann der Träger SC1 fest auf den Wärmeleitkörper SC2, welcher bereits vorher in der Bodenwanne fest angebracht z.B. punktgeschweißt war, aufgeklebt wird, und

- wenn erst danach die Bonddrähte, z.B. automatisch von einem Manipulator, angebracht werden.

Oft ist ratsam, den Wärmeleitkörper SC, SC2 zur Erhöhung seiner Wärmeleitfähigkeit sowie seiner Wärmespeicherkapazität recht massiv, also nicht zu dünn zu machen. Wenn er aber dann trotzdem weiterhin relativ dünn ist, erst recht wenn er direkt am Bodenwanne-Boden befestigt ist, ist

-zur Vergrößerung der Wärmekontaktfläche und damit zur Verbesserung des Wärmeüberganges vom Wärmeleitkörper SC, SC2 zum Federgebilde WS, sowie oft auch

-zur Verbesserung der Reibung der Federgebilde WS/WL im Seitenspalt

häufig ratsam, die das Federgebilde WS/WL berührenden Außenkanten AS des Wärmeleitkörpers SC2 in Richtung zum Deckel W hin umzubiegen, vgl. die Fig. 4, 5 und 7.

An sich übt beim Aufsetzen des unten ebenen Deckels W auf die Bodenwanne G, G1 bereits dann die Federeinheit eine Zentrierkraftkomponente in Längsrichtung aus, nämlich parallel zur Blattebene in Fig. 2 und 4 und senkrecht zur Blattebene in Fig. 3 und 5, wenn nur die Reibung der Federgebilde in den Seitenspalten die Zentrierung bewirkt. Diese in Längsrichtung wirkende Zentrierkraftkomponente kann aber leicht durch weitere Maßnahmen an der Federeinheit weiter erhöht werden:

Bei dem in den Fig. 4 und 5 gezeigten Beispiel weist, anders als bei dem in den Fig. 2 und 3 gezeigten Beispiel, die aus einem einzigen Stück Federblech hergestellte Federeinheit FE/WS/WL nicht nur zwei, sondern drei Federgebilde, also Seitenteile WS/WL auf, von denen sich das dritte, auch am Mittelteil FE hängende Federgebilde in den dritten Seitenspalt zwischen dem Wärmeleitkörper SC2 und einer dritten Seitenwand G1 der Bodenwanne stemmt. Dieser dritte Seitenspalt ist also im wesentlichen senkrecht zu den zwei anderen Seitenwänden G1 orientiert. Das dritte Federgebilde erhöht nicht nur die Verlustwärmeableitung vom Wärmeleitkörper SC2 direkt zum Deckel W als auch direkt zu den Bodenwanne-Seitenwänden G1, sondern erhöht auch die Zentrierwirkung auf den unten ebenen Deckel W, weil nun das dritte, in Fig. 4 im Schnitt gezeigte Federgebilde WS/WL eine zusätzliche Zentrierkraftkomponente in jener Längsrichtung parallel zur Blattebene der Fig. 4, also senkrecht zur Blattebene der Fig. 5 ausübt.

Eine zusätzliche, besonders große Zentrierkraft in derselben Längsrichtung kann man auch noch durch andere Maßnahmen an der Federeinheit erreichen. So kann man, vgl. Fig. 2, das Federgebilde WS/WL, selbst wenn nur zwei solche Federgebilde WS angebracht sind, so dimensionieren, daß, nach dem Aufsetzen des Deckels auf die Bodenwanne, die in Fig. 2 rechts liegende senkrechte Endkante dieser Federgebilde mehr oder weniger die Innenoberfläche der noch weiter rechts davon liegenden, geschnitten gezeigten Seitenwand der Bodenwanne als Anschlag berühren, und zwar besonders dann, wenn man beim Rollnahtschweißen des Deckels W die Rollen so über das Gehäuse laufen läßt, daß die Rollen den Deckel W in jene Längsrichtung gegen die als Anschlag dienende Bodenwanne-Seitenwand drücken.

Auch auf weitere Weise ist eine besonders große Zentrierkraft dadurch zu erreichen (in den Fig. nicht dargestellt), daß zumindest eines der Federgebilde WS/WL einen Abschnitt aufweist, welcher den Wärmeleitkörper SC, SC2 seitlich umgreift -also welcher eine Kante bzw. Fläche des Wärmeleitkörpers SC, SC2 berührt, welche um zumindest 45° gegen diejenige Wärmeleitkörperkante AS bzw. -fläche geschwenkt ist, welche die meisten sonstigen Abschnitte dieses Federgebildes WS/WL berühren. Dann weist der betreffende Abschnitt des Federgebildes eine in Längsrichtung wirkende Zentrierkraftkomponente auf.

Die Verlustwärme-Ableitung ist durch eine geschickte Wahl der Materialien weiter erhöhbar. Z.B. kann man den Wärmeleitkörper SC, SC2 aus einer -z.B. 0,5 mm dicken -CuMo-Legierung mit z.B. 53% Mo-Anteil herstellen, welche im Mittel bei $+20°$ bis $+100°$ C eine Wärmeleitfähigkeit von 226 W/m.K hat -vgl.: Ag hat 419, Cu hat 385 W/m.K. Außerdem hat die CuMo-Legierung bei $+20°$ bis $+100°$ C nahezu denselben linearen Wärmeausdehnungs-Koeffizienten, nämlich $9.10^{-6}$ $K{-};1$ wie die gebräuchlichen Keramikträger auf, vgl. BEO-Keramik/99,5% hat $9.10^{-6}$ $K{-};1$ und $Al_2O_3$-Keramik/99,5% $8,5.10^{-6}$ $K{-};1$, jedoch Ag $20,5.10^{-6}$ $K{-};1$ und Cu $17,7.10^{-6}$ $K{-};1$. Daher platzt der Keramikträger SC1 seltener vom CuMo-Wärmeleitkörper SC2 bei extremen Betriebstemperatur-Schwankungen von z.B. $-40°$ C bis zu $135°$ C ab. Vgl. damit auch, daß für solche Betriebstemperatur-Schwankungen statt der CuMo-Legierung im Prinzip auch das nur sehr schwer bearbeitbare Ti mit $8,6.10^{-6}$ $K{-};1$ und 20 W/m.F sowie das sehr teure Pt mit $9,3.10^{-6}$ $K{-};1$ und 74 W/m.K ebenfalls als Wärmeleitkörper-Material geeignet wäre, wenn der Wärmeleitkörper SC2 mit jenem Keramikträger SC1 verklebt werden soll.

Für das Federblech kann man z.B. eine CuNiBe-Legierung wählen, welche hochelastisch ist und z.B. bie +20° bei +100° C eine gute Wärmeleitfähigkeit, nämlich 230 W/m.K hat.

Wenn das Schaltungsbauteil IC ein Chip ist, ist es günstig, ihn ohne eigenem Chipgehäuse unmittelbar nakt auf dem (z.B. Keramik-) Träger SC1 oder direkt auf dem Wärmeleitkörper Sc, Sc2 zu befestigen, z.B. anzukleben oder anzulöten, damit der Wärmefluß-Widerstand zwischen dem Chip und dem Wärmeleitkörper möglichst klein wird. Außerdem sollte aus demselben Grunde möglichst nur ein gut wärmeleitender dünner flacher Träger Sc1, der auch die Zuleitungen zum Chip IC sowie den Chip IC selbst trägt, verwendet werden, um die Verlustwärme rasch über die Federeinheit und den Deckel -evtl. auch noch über die Federeinheit und die Bodenwanne-Seitenwände -an das Kühlmedium abzuleiten.

Wenn aus schaltungstechnischen Gründen sowohl die Oberseite als auch die Unterseite des Trägers Leitungen aufweist -zusätzlich zu dem, auf seiner dem Wärmeleitkörper abgewandten Oberseite, angebrachten Schaltungsbauteil IC -, besteht oft die Forderung, die Schaltungsbauteil-Unterseite (z.B. Chip-Unterseite) mit dem Potential, z.B. Masse, des Gehäuses zu verbinden. Man kann dann, evtl. sogar ganzflächig, das am Wärmeleitkörper liegende Gehäusepotential auf die Unterseite des Trägers legen also elektrisch leitend -z.B. ganzflächig -den Wärmeleitkörper mit der Träger-Unterseite verbinden, wodurch ein elektrischer Kontakt vom Gehäuse über eine Leitung, also z.B. über eine Durchkontaktierung des Trägers, zur Träger-Oberseite und damit zum Schaltungsbauteil (Chip) ermöglicht wird.

Häufig kann dann auch günstig sein, nur einen Teil der Träger-Unterseite elektrisch leitend mit dem Wärmeleitkörper-Potential zu verbinden, indem der -z.B. sogar auf seiner Ober-und Unterseite, elektrisch unisolierte Leitungen, evtl. sogar noch Dickschichtwiderstände und/oder ähnlich dünne andere elektrische Teile -tragende Träger an seiner Unterseite auf den Wärmeleitkörper mit zweierlei Klebern aufgeklebt ist, und zwar indem ein Teil der Leitungen der Unterseite des Trägers mittels eines elektrisch isolierenden Klebers, aber zumindest ein anderer Teil der Unterseite dieses Trägers mittels eines elektrisch leitenden Klebers aufgeklebt ist.

Oft ist es nötig, den Hohlraum im Gehäuse mit einem inerten Schutzgas zu füllen, besonders wenn ein Chip unmittelbar, ohne eigenes Chipgehäuse, nakt direkt auf dem Träger angebracht ist. Hierzu kann zunächst die Federeinheit in die Bodenwanne gesteckt werden, danach das Schutzgas eingefüllt werden (evt. unter vorhergehender Erwärmung des dann noch offenen Gehäuses im Vakuum), wonach der Deckel, also nach Füllung des Gehäusehohlraumes mit dem inerten Gas, z.B. mit wasserdampffreiem He-N$_2$-Gemisch, hermetisch dicht auf der Auflagefläche TF der Seitenwände befestigt wird -z.B. durch Rollnahtschweißen.

Die Figuren 6 und 7 zeigen Schnitte durch zwei weitere Beispiele der Erfindung, vgl. jeweils damit auch die Fig. 3 und 5. Statt den in Fig. 5 gezeigten, dreiseitig abgebogenen Wärmeleitkörper auf dem Boden der Bodenwanne anzubringen, kann man auch mit gleicher Aufbauhöhe eine entsprechend dicke, nicht abgebogene Wärmeleitplatte, z.B. wieder aus CuMo, anbringen, wobei z.B. auch die Fiederzungen der Federgebilde mit großer Wärmekontaktfläche an den sauber herstellbaren Seitenkanten dieses dicken Wärmeleitkörpers anliegen können. Als Wärmeleitkörper eignet sich aber auch z.B. ein brückenförmig geprägtes Blechteil z.B. entsprechend Fig. 7 wieder mit derselben Aufbauhöhe.

Bei der Erfindung und ihren Weiterbildungen kann man auch zusätzlich die Maßnahmen zur Kühlung des Schaltungsbauteils treffen, welche in der prioritätsgleichen Deutschen Patentanmeldung P.. .. ..... (VPA 84 E 2184a DE = VPA 85 P 1589 DE) beschrieben sind.

Bezugszeichenliste

AS Außenkanten
D Lichtsendediode
F Verschluß des Nebengehäuses
FE Mittelteil der Federeinheit
G Bodenplatte / Bodenwanne des Gehäuses
G1 Seitenwand der Bodenwanne
GW Gewinde
HA Hauptabschnitt des Gehäuses
IC Schaltungsbauteil / Treiber-Chip
KL Kühlmedium / Kühlluft
KP Steckerstifte
KP1 Abstandskörper
L Glasfaser
LP Lochplatte
M Mantel der Glasfaser
S optischer Stecker
SC Wärmeleitkörper
SC1 Träger
SC2 Wärmeleitkörper
SI Hohlkörper des Nebengehäuses
SO Sockel
SP Seitenspalt
TF Sektor / Auflagefläche
U Kühlrippchen
W Deckel des Gehäuses
WL Seitenteil / Fiederzungen des Federgebildes
WS Seitenteil / Federgebilde der Federeinheit

X Überwurfmutter
Z Leitungen

## Ansprüche

1. Gehäuse (W/G1/G) für ein im Betrieb Verlustwärme abgebendes Schaltungsbauteil (IC) z.B. für einen Treiber-Chip (IC), wobei

-das Gehäuse (W/G1/G) aus mindestens zwei Teilen, nämlich einer Bodenwanne (G) und einem eine im wesentlichen ebene Deckelfläche aufweisenden Deckel (W) besteht,

-ein rahmenförmiger ebener Sektor (TF) dieser ebenen Deckelfläche als Auflagefläche (TF) auf eine im wesentlichen ebenfalls ebene Auflagefläche (TF) der Seitenwände (G1) der Bodenwanne (G) dient,

-die Auflagefläche (TF) der Seitenwände (G1) - schließlich an dem Sektor (TF) befestigt, z.B. verschweißt oder verlötet wird,

-zumindest Teile der Deckelaußenoberfläche (W), welche z.B. ganz aus Metall bestehen, -evtl. auch sonstige Außenoberflächen des Gehäuses (W/G), z.B. die Außenoberflächen mancher der Seitenwände (GI) -im Betrieb durch ein fließfähiges Kühlmedium (KL), bevorzugt Kühlluft (KL), gekühlt werden,

-zumindest ein Teil der Verlustwärme vom Schaltungsbauteil (IC) über einen steifen Wärmeleitkörper (SC, SC2) und über ein gut wärmeleitendes, aus elastischem Material bestehendes Element (FE/WS/WL) an den Deckel (W) weitergeleitet wird, und

-sich jeweils mindestens ein gut wärmeleitendes, Fiederzungen (WL) aufweisendes Federgebilde - (WL/WS) in mehreren Seitenspalten zwischen den Wärmeleitkörper (SC, SC2) einerseits und zumindest zweien der Seitenwände (G1) der Bodenwanne (G) andererseits, nämlich je ein Federgebilde (WL/WS) zumindest in die zwei im wesentlichen p*h rallelen Seitenspalten zwischen den Wärmeleitkörper (SC, SC2) einerseits und zwei einander gegenüberliegenden Seitenwänden (G1) andererseits, in sich mittels seiner Fiederzungen - (WL) spreizender Weise so stemmt, daß die Federgebilde (WL/WS) jeweils durch Reibungskräfte an den Innenoberflächen dieser Seitenwände (G1) sowie an dem Wärmeleitkörper (SC, SC2) haften,

z.B. Gehäuse für ein 200-MBit/sec-Lichtsendemodul mit optischem Stecker (S/GW) und mit Treiber-Chip (IC) sowie mit einer in einem Nebengehäuse - (SI/E) des Gehäuses (W,G) angebrachten Lichtsendediode (D), z.B. wobei dieses Nebengehäuse (SI/E) in einer der Seitenwände (G1) der Bodenwanne (G) zwischen dem optischem Stecker und dem Schaltungsbauteil (IC) angebracht ist,

**dadurch gekennzeichnet, daß**

-das Element (FE) und die Federgebilde (WS/WL) einschließlich ihrer Fiederzungen (WL) gemeinsam eine einzige zusammenhängende Federeinheit - (FE/WL/WS) bilden, welche aus einem einzigen Stück Federblech mit Mittelteil (FE) und mit federnden, die Fiederzungen (WL) aufweisenden Seitenteilen (WS) hergestellt ist,

-der gut wärmeleitende Deckel (W) fest und gut wärmeleitend mit dem Mittelteil (FE) der Federeinheit (FE/WS/WL) verbunden ist, und

-die geometrischen Maße, die Federkräfte und die Reibungskräfte der Federeinheit (FE/WS/WL) so gewählt sind, daß, nach dem Aufsetzen des Deckels (W) auf die Bodenwanne (G,G1) , aber noch vor der endgültigen Befestigung des Sektors (TF) des Deckels (W) auf der Auflagefläche (TF) der Seitenwände (G1) der Bodenwanne (G), die Federeinheit (FE/WS/WL) eine - zumindest. gewisse, wenn vielleicht auch federnd nachgebende -zentrierende Halterung des Deckels (W), welche ein Verschieben des Deckels (W) gegenüber den Seitenwänden (G1) der Bodenwanne (G) erschwert oder verhindert, bildet

(Fig.2 -7).

2. Gehäuse nach Patentanspruch 1,

**dadurch gekennzeichnet, daß**

-der fest -mit dem Schaltungsbauteil (IC) verbundene Wärmeleitkörper (SC2) auf dem Boden der Bodenwanne (G) befestigt ist

(Fig. 4 -7).

3. Gehäuse nach Patentanspruch 1 oder 2,

**dadurch gekennzeichnet, daß**

-die ein Seitenteil (WS/WL) berührenden Außenkanten (AS) des Wärmeleitkörpers (SC2) jeweils in Richtung zum Deckel (W) hin umgebogen sind

(Fig. 4, 5, 7).

4. Gehäuse nach Patentanspruch 1, 2 oder 3

**dadurch gekennzeichnet, daß**

-zumindest eines der Seitenteile (WS/WL) auch einen Abschnitt aufweist, welcher eine Fläche des Wärmeleitkörpers (SC, SC2) berührt, die um zumindest 45° gegen diejenige Wärmeleitkörper-Außenkante (AS) geschwenkt ist, welche sonstige Abschnitte dieses Seitenteiles (WS/WL) berühren.

5. Gehäuse nach einem der vorhergehenden Patentansprüche,

**dadurch gekennzeichnet, daß**

-die Federeinheit zumindest drei Seitenteile aufweist, von denen zumindest das dritte Seitenteil sich in einen dritten Seitenspalt zwischen dem Wärmeleitkörper (SC2) und einer dritten, im wesentlichen senkrecht zu den zwei einander gegenüberliegenden anderen Seitenwänden (G1) orientierten, Seitenwand (GI) der Bodenwanne (G) stemmt

(Fig. 4, 5).

6. Gehäuse nach einem der vorhergehenden Patentansprüche,

**dadurch gekennzeichnet , daß**

-der Wärmeleitkörper (SC/SC2) aus einer CuMo-Legierung besteht.

7. Gehäuse nach einem der vorhergehenden Patentansprüche,

**dadurch gekennzeichnet, daß**

-das Federblech (FE/WS/WL) aus einer CuNiBe-Legierung besteht.

8. Gehäuse nach einem der vorhergehenden Patentansprüche,

**dadurch gekennzeichnet, daß**

-zwischen dem Wärmeleitkörper (SC2) und dem durch einen gehäuselosen Halbleiter-Chip (IC) gebildeten Schaltungsbauteil ein gut wärmeleitender flacher Träger (SC1), der auch Zuleitungen zum Halbleiter-Chip (IC) sowie den Halbleiter-Chip (IC) selbst trägt, eingefügt ist.

9. Gehäuse nach Patentanspruch 8,

**dadurch gekennzeichnet, daß**

-der, auf seiner dem Wärmeleitkörper zugewandten Unterseite elektrisch unisolierte Leitungen, tragende Träger (SC1) an seiner Unterseite auf den Wärmeleitkörper (SC2) mit zweierlei Klebern aufgeklebt ist, und zwar

-ein Teil der Leitungen der Unterseite des Keramikträgers mittels eines elektrisch isolierenden Klebers, aber ein anderer Teil der Leitungen dieser Unterseite des Trägers (SC1) mittels eines elektrisch (z.B. Erdpotential) leitenden Klebers aufgeklebt ist.

10. Gehäuse nach einem der vorhergehenden Patentansprüche,

**dadurch gekennzeichnet, daß**

-der Deckel (W) nach Füllung des Gehäusehohlraumes mit einem inerten Gas, z.B. mit einem wasserdampffreien He-N$_2$-Gemisch, hermetisch dicht auf der Auflagefläche der Seitenwände (G1) befestigt ist.

# FIG 1

U

5 — 16,2

W

29

W    W

3....6

13

X    X    X

LP

6,35

M/L         M/L

M/L

KL         KL

(40°C,100m/min)

# FIG 2

KL → GW   TF          W    FE    III        WS  TF

M/L

Z

E

SI    D

WL

S                              G

KL

G    LP   KP    SO  IC        III  SC

HA

## FIG 4

## FIG 3

## FIG 5

## FIG 6

## FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 088 246 (IBM)<br>* Figuren 1,2; Ansprüche 1-3,6 * | 1 | H 01 L 23/46 |
| | --- | | |
| A | PATENTS ABSTRACTS OF JAPAN, Band 8, Nr. 78 (E-237)[1515], 10. April 1984; & JP-A-58 225 659 (MITSUBISHI DENKI K.K.) 27.12.1983 | 1 | |
| | --- | | |
| A | EP-A-0 020 911 (IBM)<br>* Figuren 1-4; Anspruch 1 * | 1 | |
| | --- | | |
| A | DE-A-3 129 996 (SIEMENS)<br>* Anspruch * | 1 | |
| | ----- | | |
| | | | **RECHERCHIERTE SACHGEBIETE (Int. Cl.4)**<br><br>H 01 L |

Der vorliegende Recherchenbericht wurde für alle Patentansprüche erstellt.

| Recherchenort<br>DEN HAAG | Abschlußdatum der Recherche<br>27-11-1986 | Prüfer<br>DE RAEVE R.A.L. |
|---|---|---|